Europäisches Patentamt

(19) European Patent Office

Office européen des brevets

(11) Publication number : **0 345 675 B1**

(12) **EUROPEAN PATENT SPECIFICATION**

(45) Date of publication of patent specification :
04.01.95 Bulletin 95/01

(51) Int. Cl.[6] : **H03H 21/00**

(21) Application number : **89110080.2**

(22) Date of filing : **03.06.89**

(54) **Hybrid stochastic gradient for convergence of adaptive filters.**

(30) Priority : **09.06.88 US 204615**

(43) Date of publication of application :
**13.12.89 Bulletin 89/50**

(45) Publication of the grant of the patent :
**04.01.95 Bulletin 95/01**

(84) Designated Contracting States :
**DE FR GB IT NL**

(56) References cited :
**IEEE TRANSACTIONS ON COMMUNI-
CATIONS. vol. 34, no. 12, December 1986,
NEW YORK US pages 1272 - 1275; C.P.
KWONG: "Dual sign algorithm for adaptive
filtering"
IEEE ACOUSTICS, SPEECH, AND SIGNAL
PROCESSING MAGAZINE. vol. 34, no. 2, April
1986, NEW YORK US pages 309 - 316; R.W.
HARRIS et al.: "A variable step (VS)adaptive
filter algorithm"**

(56) References cited :
**CONF. RECORD OF THE 9TH ASILOMAR
CONF. ON CIRCUITS, SYSTEMS & COMPU-
TERS 06 November 1985, PACIFIC GROVE US
pages 509 -513; T. J. SHAN et al.: "Adaptive
filtering algorithms with automatic gain con-
trol"**

(73) Proprietor : **NATIONAL SEMICONDUCTOR
CORPORATION
2900 Semiconductor Drive
P.O. Box 58090
Santa Clara California 95051-8090 (US)**

(72) Inventor : **Batruni, Roy G.
6187-I Joaquin Murieta
Newark, CA. 94560 (US)**
Inventor : **Wilson, Howard A.
3573 Cabrillo Avenue
Santa Clara, CA. 95051 (US)**

(74) Representative : **Sparing - Röhl - Henseler
Patentanwälte
Postfach 14 04 43
D-40074 Düsseldorf (DE)**

EP 0 345 675 B1

## Description

The present invention relates to telecommunications systems and, in particular, to an adaptive filtering coefficient update technique that combines features of the least mean squares algorithm and the sign algorithm to arrive at a hybrid stochastic gradient algorithm that is both fast and consistently convergent.

Two common adaptive filtering coefficient update algorithms are the Least Mean Squares (LMS) and the Sign Algorithm (SA). The LMS method is not consistently successful in converging a filter. However, in those situations where it does operate successfully, it is fast. The SA method, on the other hand, always succeeds, but it is slow.

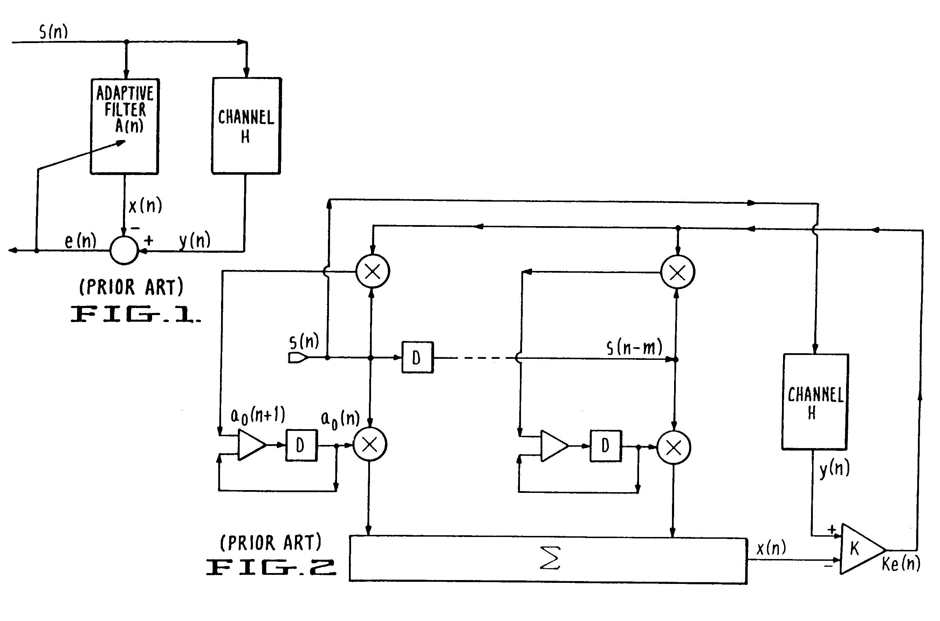

A typical adaptive filtering application, shown in Fig. 1, involves driving a channel with an unknown impulse response H,

$$H' = (h_0\ h_1 \ldots h_m) \quad (1)$$

where the ' character denotes transposition, with a known input signal S(n),

$$S'(n) = (s(n)\ s(n - 1) \ldots s(n - m)) \quad (2)$$

The output of the channel at time n is given by the convolution sum,

$$y(n) = \sum_{j=0}^{m} h_j\ s(n-j) = S'(n)\ H. \quad (3)$$

In adaptively tracking the channel output, the adaptive filter produces an output x(n),

$$x(n) = S'(n)\ A(n) \quad (4)$$

where

$$A'(n) = (a_0(n)\ a_1(n) \ldots a_m(n)) \quad (5)$$

is the adaptive filter impulse response at time n.

Being time variable, the adaptive filter coefficients are updated as follows,

$$A(n + 1) = A(n) + g(n)\ f_1(e(n))\ f_2(S(n)) \quad (6)$$

$$e(n) = y(n) - x(n) \quad (7)$$

where e(n) is the prediction error, g(n) is a gain that can be either constant or time variable, and $f_1(.)$ and $f_2(.)$ are generalized functions.

Adhering to adaptive filtering terminology, it is said that "convergence" is achieved when

$$A(n) = H \text{ for all n,} \quad (8)$$

$$e(n) = 0 \text{ for all n,} \quad (9)$$

In practice, Equations (8) and (9) above will not be exact equalities. Rather, there will be a misadjustment between A(n) and H, and $0 < |e(n)| < \rho$, where $\rho$ is small, i.e. the practical limit of the algorithm.

Both the Least Mean Squares algorithm and the Sign Algorithm have received extensive treatment in the theoretical literature and have found wide practical application.

Referring to Fig. 2, which shows a possible circuit implementation of the LMS algorithm, the LMS algorithm structure may be expressed as follows:

$$A(n + 1) = A(n) + K\ e(n)\ S(n) \quad (10)$$

where K is a constant positive coefficient adaption step size. The choice of K for an assured convergence is discussed by B. Widrow et al., "Stationary and Non-Stationary Learning Characteristics of the LMS Adaptive Filter", Proceedings of the IEEE, vol. 64, pp. 1151-1162, Aug. 1976.

If K is chosen according to the criteria set forth by Widrow et al, then convergence is assured. However, in practical telecommunications applications, the channel H over which echo cancellation or equalization is being performed is not known. Consequently, it is impossible to determine K a priori, and convergence is not guaranteed over any arbitrary channel. When convergence does take place, the result is the minimization of the expected value of the error squared $u = E(e(n)^2)$; that is, the error variance is minimized. The product e(n)S(n) used in Eq. (10) above is a biased estimate of the slope of the expected value of the error squared w=dv/dA(n).

In a digital implementation of the LMS algorithm, when convergence starts, e(n) is large and K is typically fixed at $K=1/(2^{11})$; the coefficients A(n) are 24 bits wide (1 sign bit + 23 magnitude bits). The product p=Ke(n) is equivalent to shifting e(n) to the right by 11 places and, initially, when e(n) is large, p is still on average such that $|p| > 1/(2^{23})$ and, therefore, this update is "seen" by A(n). However, as convergence progresses and e(n) becomes smaller as desired, $|p| < 1/(2^{23})$ and the coefficients A(n) are not being updated anymore. Therefore, convergence is not optimal, since by using more than 24 bits for A(n), convergence could have proceeded and e(n) could have been further decreased.

The LMS algorithm has also shown parameter drift properties that are described by Sethares et al, "Parameter Drift in LMS Adaptive Filters", IEEE Transactions on Acoustics, Speech and Signal Processing, Vol.ASSP-34 No. 4, August 1986, and have been observed in a working prototype. The problem is that, with bounded steady state inputs, the output $x(n)$ and the error $e(n)$ remain bounded and approximately zero, respectively, while the parameters $A(n)$ drift away from H very slowly.

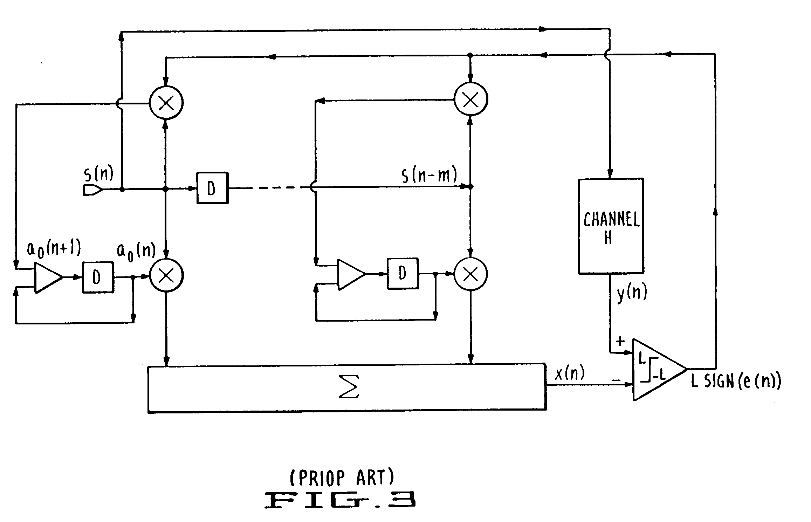

Referring to Fig. 3, which shows a possible circuit implementation of the Sign Algorithm, the Sign Algorithm structure may be expressed as follows:

$$A(n + 1) = A(n) + L\,\text{sign}(e(n))\,S(n) \quad (11)$$

where L is a constant positive step size, usually equal to the least significant bit in the coefficients $A(n)$. Convergence is achieved for any positive L, as discussed by A. Gersho, "Adaptive Filtering With Binary Reinforcement", IEEE Transactions on Information Theory, Vol. IT-30, No. 2, March 1984.

For the same desired residual error variance as the LMS technique described above, the convergence time for the Sign Algorithm is always longer than the LMS algorithm, as described by Gersho and by T.A.C.M. Claasen and W.F.G. Mecklenbrauker, "Comparison of the Convergence of Two Algorithms for Adaptive FIR Digital Filters", IEEE Transactions on Circuits and Systems, Vol. CAS-28, No. 6, June 1981. Implementation of the Sign Algorithm is simpler than the LMS algorithm, since $p=Ke(n)$ in LMS becomes $+L$ or $-L$ in the Sign Algorithm. When convergence is achieved, the Sign Algorithm minimizes the expectation of the absolute value of the error, $E(|e(n)|)$. In the course of convergence and after it is achieved, in a digital implementation, the coefficient vectors $A(n)$ always "see" the updating increment, since to every coefficient of $A(n)$, a least significant bit is added or subtracted depending on $\text{sign}(e(n))$ and the corresponding $s(n-j)$.

No parameter drift has been observed in the Sign Algorithm. A theoretical reason is not known, but it is believed that the hard limiting of the error signal gives an unbiased estimate of $w=dv/dA(n)$, which is essential for the stability of the steady state convergence.

The present invention is defined by the patent claims. The features in their pre-characterizing parts are known from IEEE TRANSACTIONS ON COMMUNICATIONS vol. 34 #12 Dec. 1986, NEW YORK, pages 1272-1275.

The present invention provides a technique for updating the coefficients $a(n)$ of an adaptive filter impulse response $A(n)$, where

$$A'(n) = (a_0(n)\, a_1(n) \ldots a_m(n))$$

is the adaptive filter impulse response at time n. The impulse response is utilized for tracking the output $y(n)$ of a communications channel, where

$$y(n) = \sum_{j=0}^{m} h_j\, s(n-j) = S'(n)\, H$$

where H is an unknown impulse response of the channel,

$$H' = (h_0\, h_1 \ldots h_m),$$

the ' character denoting transposition. The channel is driven with a known input signal $S(n)$, where

$$S'(n) = (s(n)\, s(n - 1) \ldots s(n - m)).$$

According to the technique, the output $x(n)$ of an adaptive filter, where

$$x(n) = S'(n)\, A(n)$$

is compared with the channel output $y(n)$ according to a first convergence algorithm, the Least Mean Squares algorithm, to develop a first error prediction signal. At the same time the adaptive filter output $x(n)$ is compared with the channel output $y(n)$ according to a second convergence algorithm, the Sign Algorithm, to develop a second error prediction signal. If the Least Mean Squares error signal is greater than or equal to a preselected value, then it is used to update the coefficients $a(n)$ of the adaptive filter impulse response. If the Least Mean Squares error signal is less than the preselected value, then the Sign Algorithm error signal is used to update the coefficients $a(n)$.

A better understanding of the features and advantages of the present invention will be obtained by reference to the following detailed description of the invention and accompanying drawings which set forth an illustrative embodiment in which the principles of the invention are utilized.

Figure 1 is a simple schematic block diagram illustrating a typical application of an adaptive filter.

Figure 2 is a schematic block diagram illustrating an embodiment of an adaptive filter using the Least Mean Squares algorithm.

Figure 3 is a schematic block diagram illustrating an embodiment of an adaptive filter using the Sign Algorithm.

Figure 4 is a schematic block diagram illustrating an embodiment of an adaptive filter using the hybrid stochastic gradient algorithm in accordance with the present invention.

Both the Least Mean Squares (LMS) and the Sign Algorithm (SA) described above belong to the family of stochastic gradient algorithms. These algorithms update the adaptive filter coefficients such that the error moves in a negative gradient sense on the average. Therefore, in a stochastic fashion, the error gradient is evaluated by $-g(n)f1(e(n))f2(S(n))$ in Equation (6) above and the coefficients are changed in the opposite direction.

Combining the LMS and SA yields another stochastic gradient algorithm, identified herein as the Hybrid Stochastic Gradient (HSG), since the gradient will have one of two possible estimation methods at each time point.

Let $\sim$ denote raising to a power, and M equal the number of magnitude bits in each coefficient in A(n). Then, at time n,

1) $c = \text{sign} (e(n))$;
2) $d = K e(n)$;
3) if $|d| \geq 2\sim(-M)$, then d is unchanged;
4) if $|d| < 2\sim(-M)$, then $d = c \, 2\sim(-M)$; and
5) $A(n+1) = A(n) + d \, S(n)$.

The properties of the HSG are:

Initially, when e(n) is large, the HSG behaves as a LMS algorithm with fast convergence. In those cases where a channel exists for which K does not result in convergence for the LMS, the HSG behaves as a SA and has guaranteed, albeit slow, convergence.

As convergence proceeds and e(n) becomes small, step (4) above becomes dominant. That is, the HSG switches automatically to an SA format and the updates are still seen by the coefficients. In the steady state, the HSG behaves according to the SA and, therefore, it minimizes $E(|e(n)|)$.

Thus, the HSG exhibits both the speed of the LMS as well as the guaranteed convergence of the SA. Since, in steady state, it behaves according to the SA, the unbiased estimates of $w=dv/dA(n)$ enable it to avoid the parameter drift problem found in the LMS.

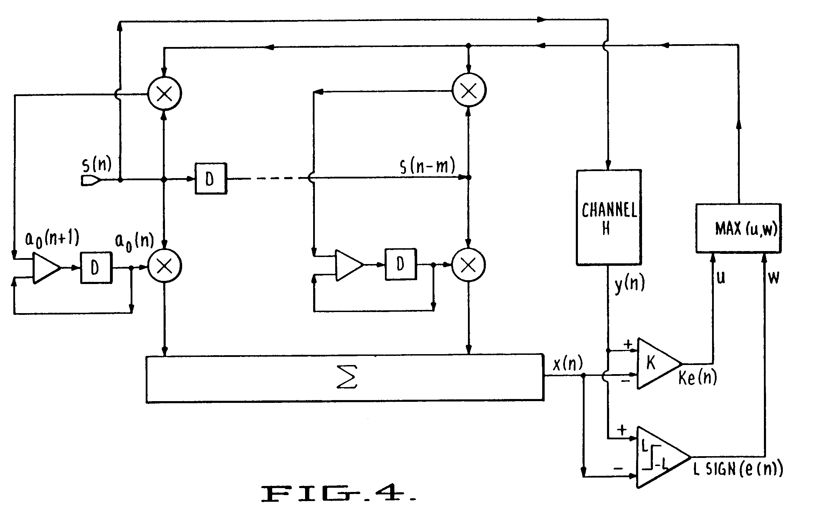

Figure 4 shows an circuit implementation of the Hybrid Stochastic Gradient (HSG).

The impulse response A(n) of an adaptive filter at time n where

$$A'(n) = (a_0(n) \, a_1(n) \ldots a_m(n)),$$

is utilized for tracking the output y(n) of a communications channel, where

$$y(n) = \sum_{j=0}^{m} h_j \, s(n-j) = S'(n) \, H$$

H being the unknown impulse response of the channel, where

$$H' = (h_0 \, h_1 \ldots h_m).$$

The ' character denotes transposition. The channel is driven with a known input signal S(n), where

$$S'(n) = (s(n) \, s(n-1) \ldots s(n-m)).$$

The adaptive filter generates an output x(n), where

$$x(n) = S'(n) \, A(n).$$

The channel output y(n) is compared with the adaptive filter output x(n) according to the LMS to develop a first error prediction signal Ke(n). Simultaneously, the channel output y(n) is compared with the adaptive filter output x(n) according to the SA to develop a second error prediction signal L Sign (e(n)). If the LMS error signal is greater than or equal to a preselected value, then it is used to update the coefficients a(n) of the adaptive filter impulse response. If the LMS error signal is less than the preselected value, then the SA error signal is used to update the coefficients a(n).

Advantages of the LMS and SA complement each other. By combining those algorithms into one, the HSG of the present invention, these advantages are obtained in one algorithm. Thus, the HSG provides speed of convergence, assured convergence, steady state stability and optimal residual error in the absolute value sense.

It should be understood that the scope of the present invention is not intended to be limited by the specifics of the above-described embodiment, but rather is defined by the accompanying claims.

EP 0 345 675 B1

**Claims**

1. A method for updating the coefficients a(n) of an adaptive filter impulse response A(n) where

$$A'(n) = (a_0(n)\, a_1(n) \ldots a_m(n))$$

is the adaptive filter impulse response at time n, the impulse response utilizable for adaptively tracking the output y(n) of a communications channel, where

$$y(n) = \sum_{j=0}^{m} h_j\, s(n-j) = S'(n)\, H$$

where H is an unknown impulse response of the channel,

$$H' = (h_0\, h_1 \ldots h_m),$$

the ′ character denoting transposition, the channel being driven with a known input signal S(n), where

$$S'(n) = (s(n)\, s(n-1) \ldots s(n-m)),$$

the method comprising:

(a) generating an adaptive filter output x(n), where

$$x(n) = S'(n)\, A(n);$$

(b) comparing the channel output y(n) and the adaptive filter output x(n) according to a first convergence algorithm to develop a first error prediction signal;

(c) comparing the channel output y(n) and the adaptive filter output x(n) according to a second convergence algorithm to develop a second error prediction signal;

(d) selecting between the first error prediction signal and the second error prediction based on pre-established criteria; and

(e) utilizing the selected error prediction signal to update the adaptive filter impulse response coefficients a(n), characterized in that the first convergence algorithm is the Least Mean Squares Algorithm and the second convergence algorithm is the Sign Algorithm, the first error prediction signal being selected if it is greater than or equal to a preselected value, and the second error prediction signal being selected otherwise.

2. Apparatus for updating the coefficients a(n) of an adaptive filter impulse response A(n) where

$$A'(n) = (a_0(n)\, a_1(n) \ldots a_m(n))$$

is the adaptive filter impulse response at time n, the impulse response utilizable for adaptively tracking the output y(n) of a communications channel, where

$$y(n) = \sum_{j=0}^{m} h_j\, s(n-j) = S'(n)\, H$$

where H is an unknown impulse response of the channel,

$$H' = (h_0\, h_1 \ldots h_m),$$

the ′ character denoting transposition, the channel being driven with a known input signal S(n), where

$$S'(n) = (s(n)\, s(n-1) \ldots s(n-m)),$$

the apparatus comprising:

(a) an adaptive filter having an output x(n), where

$$x(n) = S'(n)\, A(n);$$

(b) first means for comparing the channel output y(n) and the adaptive filter output x(n) according to a first convergence algorithm to develop a first error prediction signal;

(c) second means for comparing the channel output y(n) and the adaptive filter output x(n) according to a second convergence algorithm to develop a second error prediction signal;

(d) means for selecting between the first error prediction signal and the second error prediction signal based on pre-established criteria; and

(e) means for utilizing the selected error prediction signal to update the adaptive filter impulse response coefficients a(n), characterized in that the first convergence algorithm is the least Mean Squares Algorithm and the second convergence algorithm is the Sign Algorithm, the first error prediction signal being selected if it is greater than or equal to a preselected value, and the second error prediction signal being selected otherwise.

5

**Patentansprüche**

1. Ein Verfahren für das Auffrischen der Koeffizienten a(n) eines Impulsverhaltens A(n) eines adaptiven Filters, worin

$$A'(n) = (a_0(n)\, a_1(n) \ldots a_m(n))$$

die Impulsreaktion des adaptiven Filters zu einem Zeitpunkt n ist, wobei die Impulsreaktion verwertbar ist für das adaptive Verfolgen des Ausgangs y(n) eines Kommunikationskanals, worin

$$y(n) = \sum_{j=0}^{m} h_j\, s(n-j) = S'(n)\, H$$

worin H eine unbekannte Impulsreaktion des Kanals ist,

$$H' = (h_0\, h_1 \ldots h_m),$$

wobei das '-Zeichen die Transposition bezeichnet, wobei der Kanal angesteuert wird mit einem bekannten Eingangssignal S(n), wobei

$$S'(n) = (s(n)\, s(n - 1) \ldots s(n - m)),$$

welches Verfahren umfaßt:

(a) Erzeugen eines Ausgangs x(n) eines adaptiven Filters, wobei

$$x(n) = S'(n)\, A(n);$$

ist;

(b) Vergleichen des Kanalausgangs y(n) und des Ausgangs x(n) des adaptiven Filters entsprechend einem ersten Konvergenzalgorithmus zum Entwickeln des ersten Fehlervorhersagesignals;

(c) Vergleichen des Kanalausgangs y(n) und des Ausgangs x(n) des adaptiven Filters entsprechend einem zweiten Konvergenzalgorithmus zum Entwickeln eines zweiten Fehlervorhersagesignals;

(d) Wählen zwischen dem ersten Fehlervorhersagesignal und der zweiten Fehlervorhersage, basierend auf vorgegebenen Kriterien; und

(e) Verwerten des ausgewählten Fehlervorhersagesignals zum Auffrischen der Impulsreaktionskoeffizienten a(n) des adaptiven Filters, dadurch gekennzeichnet, daß der erste Konvergenzalgorithmus der Algorithmus der kleinsten mittleren Quadrate ist und der zweite Konvergenzalgorithmus der Vorzeichenalgorithmus ist, wobei das erste Fehlervorhersagesignal ausgewählt wird, wenn es größer oder gleich einem vorgewählten Wert ist, und das zweite Fehlervorhersagesignal in den übrigen Fällen ausgewählt wird.

2. Vorrichtung für das Auffrischen der Koeffizienten a(n) einer Impulsreaktion a(n) eines adaptiven Filters, worin

$$A'(n) = (a_0(n)\, a_1(n) \ldots a_m(n))$$

die Impulsreaktion des adaptiven Filters beim Zeitpunkt n ist, welche Impulsreaktion verwertbar ist für das adaptive Verfolgen des Ausgangs y(n) eines Kommunikationskanals, worin

$$y(n) = \sum_{j=0}^{m} h_j\, s(n-j) = S'(n)\, H$$

wobei H eine unbekannte Impulsreaktion des Kanals ist,

$$H' = (h_0\, h_1 \ldots h_m),$$

wobei das '-Zeichen die Transposition bezeichnet, welcher Kanal angesteuert wird mit einem bekannten Eingangssignal S(n), worin

$$S'(n) = (s(n)\, s(n - 1) \ldots s(n - m)),$$

welche Vorrichtung umfaßt:

(a) ein adaptives Filter mit einem Ausgang x(n), worin

$$x(n) = S'(n)\, A(n);$$

(b) erste Mittel für das Vergleichen des Kanalausgangs y(n) und des adaptiven Filterausgangs x(n) entsprechend einem ersten Konvergenzalgorithmus zum Entwickeln eines ersten Fehlervorhersagesignals;

(c) zweite Mittel für das Vergleichen des Kanalausgangs y(n) und des Ausgangs x(n) des adaptiven Filters entsprechend einem zweiten Konvergenzalgorithmus zum Entwickeln eines zweiten Fehlervorhersagesignals;

(d) Mittel für das Auswählen zwischen dem ersten Fehlervorhersagesignal und dem zweiten Fehlervorhersagesignal, basierend auf vorbestimmten Kriterien; und

(e) Mittel für das Verwerten des ausgewählten Fehlervorhersagesignals zum Auffrischen der Impulsreaktionskoeffizienten a(n) des adaptiven Filters, dadurch gekennzeichnet, daß der erste Konvergenzalgorithmus der Algorithmus der kleinsten mittleren Quadrate ist und der zweite Konvergenzalgorithmus der Vorzeichenalgorithmus ist, wobei das erste Fehlervorhersagesignal ausgewählt wird, wenn es größer oder gleich einem vorgewählten Wert ist, und das zweite Fehlervorhersagesignal in den anderen Fällen ausgewählt wird.

## Revendications

1. Procédé pour ajuster dynamiquement les coefficients a(n) de la réponse impulsionnelle A(n) d'un filtre ajustable où

$$A'(n) = (a_0(n)\, a_1(n) \dots a_m(n))$$

est la réponse impulsionnelle du filtre ajustable à l'instant n, la réponse impulsionnelle étant utilisable pour suivre de manière dynamique la sortie y(n) d'un canal de communication, où

$$y(n) = \sum_{j=0}^{m} h_j\, s(n-j = S'(n)\ H$$

où H est la réponse impulsionnelle inconnue du canal,

$$H' = (h_0\, h_1 \dots h_m),$$

le signe ' indiquant la transposition, le canal étant attaqué avec un signal d'entrée connu S(n), où

$$S'(n) = (s(n)\, s(n - 1) \dots s(n - m)).$$

le procédé comprenant les étapes de :

(a) engendrer un signal de sortie de filtre ajustable x(n), où

$$x(n) = S'(n)\, A(n);$$

(b) comparer la sortie de canal y(n) et la sortie du filtre ajustable x(n) conformément à un premier algorithme de convergence pour produire un premier signal d'erreur de prédiction;

(c) comparer la sortie de canal y(n) et la sortie du filtre ajustable x(n) conformément à un deuxième algorithme de convergence pour produire un deuxième signal d'erreur de prédiction;

(d) choisir soit le premier, soit le deuxième signal d'erreur de prédiction conformément à des critères préétablis; et

(e) utiliser le signal d'erreur de prédiction choisi pour ajuster dynamiquement les coefficients a(n) de réponse impulsionnelle du filtre ajustable, caractérisé en ce que le premier algorithme de convergence et l'algorithme du moindre carré moyen et le deuxième algorithme de convergence et l'algorithme du signe, le premier signal de prédiction d'erreur étant sélectionné s'il est plus grand ou égal à une valeur présélectionnée, et le deuxième signal d'erreur étant sélectionné dans l'autre cas.

2. Appareil pour ajuster dynamiquement les coefficients a(n) de la réponse impulsionnelle A(n) d'un filtre ajustable où

$$A'(n) = (a_0(n)\, a_1(n) \dots a_m(n))$$

est la réponse impulsionnelle du filtre ajustable à l'instant n, la réponse impulsionnelle étant utilisable pour suivre dynamiquement la sortie y(n) d'un canal de communication, où

$$y(n) = \sum_{j=0}^{m} h_j\, s(n-j = S'(n)\ H$$

où H est la réponse impulsionnelle inconnue du canal,

$$H' = (h_0\, h_1 \dots h_m),$$

le signe ' indiquant une transposition, le canal étant attaqué avec un signal d'entrée connu S(n), où

$$S'(n) = (s(n)\, s(n - 1) \dots s(n - m)).$$

l'appareil comprenant :

(a) un filtre ajustable ayant une sortie x(n), où

7

$$x(n) = S'(n)A(n);$$

(b) des premiers moyens pour comparer la sortie du canal y(n) et la sortie du filtre ajustable x(n) conformément à un premier algorithme de convergence pour produire un premier signal de prédiction d'erreur;

(c) des deuxièmes moyens pour comparer la sortie du canal y(n) et la sortie du filtre ajustable x(n) conformément à un deuxième algorithme de convergence pour produire un deuxième signal de prédiction d'erreur.

(d) des moyens pour choisir entre le premier signal de prédiction d'erreur et le deuxième signal de prédiction d'erreur selon un critère préétabli; et

(e) des moyens pour utiliser le signal de prédiction d'erreur choisi pour ajuster dynamiquement les coefficients a(n) de réponse impulsionnelle du filtre ajustable, caractérisé en ce que le premier algorithme de convergence et l'algorithme du moindre carré moyen et le deuxième algorithme de convergence et l'algorithme du signe, le premier signal de prédiction d'erreur étant sélectionné s'il est plus grand ou égal à une valeur présélectionné, et le deuxième signal de prédiction d'erreur étant sélectionné dans l'autre cas.

S(n)

ADAPTIVE
FILTER
A(n)

CHANNEL
H

$x(n)$

$e(n)$   $-$   $+$   $y(n)$

(PRIOR ART)

FIG.1.

$S(n)$

$S(n-m)$

D

CHANNEL
H

$a_0(n+1)$   $a_0(n)$

D

$y(n)$

$\Sigma$   $x(n)$   $+$   K   $-$   $Ke(n)$

(PRIOR ART)

FIG.2

(PRIOR ART)
FIG. 3

FIG.4.